# EUROPEAN PATENT APPLICATION

(11) **EP 3 608 975 A1**
(43) Date of publication of application: **12.02.2020**
(21) Application number: 19157456.5
(22) Date of filing: 15.02.2019
(51) Int. Cl.: H01L 31/05

(54) **METHODS OF MANUFACTURING A SHINGLED SOLAR MODULE**

(30) Priority: 09.08.2018 CN 201810901663
(71) Applicant: Flex, Ltd., Singapore 486123 (SG)
(72) Inventor: ZHOU, Lisong, Freemont, CA 94539 (US); ZHOU, Huaming, Wuxi Jiangsu (CN)
(74) Representative: v. Bezold & Partner Patentanwälte - PartG mbB

(57) **Abstract**

The present disclosure describes a method of forming a solar sub-assembly including etching a solar cell, singulating the solar cell to form a plurality of strips, each strip including at least a bus bar, screen printing electrically conductive adhesive (ECA) onto at least one edge of the singulated strips of the solar cell, and shingling the singulated strips such that the ECA bonds one of the plurality of strips to another to form a string.

## Description

### Technical Field

The present disclosure relates to solar modules, and more particularly, to solar cells incorporated into shingled array module ("SAM"), and methods of manufacturing a solar module of bonded solar cells in a shingled array.

### Background

Over the past few years, the use of fossil fuels as an energy source has been trending downward. Many factors have contributed to this trend. For example, it has long been recognized that the use of fossil fuel-based energy options, such as oil, coal, and natural gas, produces gases and pollution that may not be easily removed from the atmosphere. Additionally, as more fossil fuel-based energy is consumed, more pollution is discharged into the atmosphere causing harmful effects on life close by. Despite these effects, fossil-fuel based energy options are still being depleted at a rapid pace and, as a result, the costs of some of these fossil fuel resources, such as oil, have risen. Further, as many of the fossil fuel reserves are located in politically unstable areas, the supply and costs of fossil fuels have been unpredictable.

Due in part to the many challenges presented by these traditional energy sources, the demand for alternative, clean energy sources has increased dramatically. To further encourage solar energy and other clean energy usage, some governments have provided incentives, in the form of monetary rebates or tax relief, to consumers willing to switch from traditional energy sources to clean energy sources. In other instances, consumers have found that the long-term savings benefits of changing to clean energy sources have outweighed the relatively high upfront cost of implementing clean energy sources.

One form of clean energy, solar energy, has risen in popularity over the past few years. Advancements in semiconductor technology have allowed the designs of solar modules and solar panels to be more efficient and capable of greater output. Further, the materials for manufacturing solar modules and solar panels have become relatively inexpensive, which has contributed to the decrease in costs of solar energy. As solar energy has increasingly become an affordable clean energy option for individual consumers, solar module and panel manufacturers have made available products with aesthetic and utilitarian appeal for implementation on residential structures. As a result of these benefits, solar energy has gained widespread global popularity.

### Summary

The present disclosure is directed to a method of forming solar sub-assemblies. Specifically the method includes etching a solar cell, singulating the solar cell to form a plurality of strips, each strip including at least a bus bar, screen printing electrically conductive adhesive (ECA) onto at least one edge of the singulated strips of the solar cell, and shingling the singulated strips such that the ECA bonds one of the plurality of strips to another to form a string.

The method may include applying a mask to the singulated strips of the solar cell to prevent adhesion of the ECA except where desired. The ECA may be printed onto at least 100 singulated strips at a time.

The method may include shingling 10 or more, 30 or more, or 100 or more singulated strips to form a string. Two or more strings may be electrically connected in parallel using a bus bar at both ends of the strings to form a set of strings. The two or more sets may be connected electrically in series to form solar module.

In accordance with an aspect the screen printing occurs applies ECA to substantially cover the at least one bus bar. Additionally or alternatively, the screen printing may apply a series of ECA dots, each having a length less than the full length of the bus bar.

In accordance with a further aspect, the shingling requires overlaying an edge of a first singulated strip on which ECA has been applied on a first side, with a second edge of a second singulated strip on which no ECA has been applied. This may be repeated until a desired length of a string has been achieved.

### Brief Description of the Drawings

Various aspects of the present disclosure are described hereinbelow with reference to the drawings, which are incorporated in and constitute a part of this specification, wherein:
Fig. 1 is a top view of a solar cell in accordance with the present disclosure;
Fig. 2 is a bottom view of a solar cell in accordance with the present disclosure;
Fig. 3 is a flow chart outlining a method of forming a string of strips in accordance with the present disclosure;
Fig. 4 is a schematic view of a scribing system in accordance with the present disclosure;
Fig. 5 is a top view of a singulated solar cell in accordance with the present disclosure;
Fig. 6 is a side view of shingled solar cell strips in accordance with a present disclosure;
Fig. 7 is a top view of a string of rectangular strips in accordance with the present disclosure;
Fig. 8 is a top view of a string of chamfered strips in accordance with the present disclosure;
Fig. 9 is a top view of a solar module in accordance with the present disclosure; and
Fig. 10 is a close-up view of a portion of the solar module of Fig. 9.

### Detailed Description

Further details and aspects of exemplary embodiments of the present disclosure are described in more detail below with reference to the appended figures.

With reference to FIG's. 1-2, various views of a solar cell 100 are provided, according to an embodiment of the present disclosure. The solar cell 100 is made up of a substrate 101 configured to be capable of producing energy by converting light energy into electricity. Examples of suitable photovoltaic material include, but are not limited to, those made from multicrystalline or monocrystalline silicon wafers. These wafers may be processed through the major solar cell processing steps, which include wet or dry texturization, junction diffusion, silicate glass layer removal and edge isolation, silicon nitride anti-reflection layer coating, front and back metallization including screen printing, and firing. The wafers may be further processed through advanced solar cell processing steps, including adding rear passivation coating and selective patterning to thereby obtain a passivated emitter rear contact (PERC) solar cell, which has a higher efficiency than solar cells formed using the standard process flow mentioned above. The solar cell 100 is a p-type monocrystalline cell, in an embodiment, but may be a p-type multicrystalline or an n-type monocrystalline cell in other embodiments. Similar to the diffused junction solar cells described as above, other high efficiency solar cells, including heterojunction solar cells and bifacial solar cells, can utilize the same or similar metallization patterns in order to be used for the manufacture of a shingled array module. The solar cell 100 may have a substantially square shape with chamfered corners (a pseudo-square) or a full square shape. As illustrated in the figures, these options are depicted with dashed lines showing the alternative configurations.

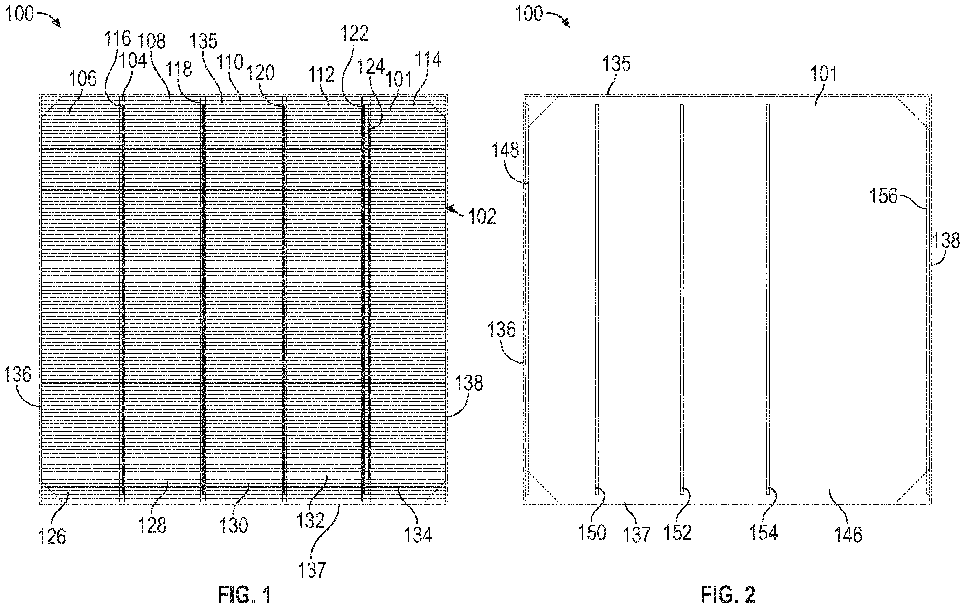

As illustrated in FIG. 1, the solar cell 100 has a metallization pattern 102 formed on a front side 104 of the substrate 101. The metallization pattern 102 generally includes a plurality of discrete sections 106, 108, 110, 112, 114, each of which has a front side bus bar 116, 118, 120, 122, 124 and finger lines 126, 128, 130, 132, 134. The discrete sections 106, 108, 110, 112, 114 are patterned such that, as will be described later, each discrete section 106, 108, 110, 112, 114 can be separated from the solar cell 100 to form a strip. As such, the sections 106, 108, 110, 112, 114 may be separated by a gap, which serves as a portion of the solar cell 100 at which a break may be made. The width of the gap, if included, is in a range of about 0.2 mm to about 2.0 mm. Here, five discrete sections 106, 108, 110, 112, 114 are included to thereby form five strips total. The front side bus bars 116, 118, 120, 122, 124 are substantially parallel to each other, and each extends along a length of the solar cell 100 without intersecting the top and bottom edges 135, 137 of the solar cell 100.

A back side 146 of the solar cell 100 likewise includes metallization, as illustrated in FIG. 2. In an embodiment, the back side 146 includes a plurality of back side bus bars 148, 150, 152, 154, 156, the total number of which is equal to the number of front side bus bars 116, 118, 120, 122, 124. Each back side bus bar 148, 150, 152, 154, 156 corresponds to a discrete section 106, 108, 110, 112, 114. In an embodiment, the location of each back side bus bar 148, 150, 152, 154, 156 depends on the location of a corresponding front side bus bar 116, 118, 120, 122, 124. Specifically, upon cleaving the solar cell 100 into a plurality of strips, each strip has a front side bus bar 116, 118, 120, 122, 124 on an edge opposite from an edge on which a back side bus bar 148, 150, 152, 154, 156 is formed.

The particular locations of the front and back side bus bars are strategically selected. In particular, the front side bus bars may be formed at locations that are away from one or both of the edges of the solar cell 100, which thereby reduces side leakage and improves shunt resistance. As a result, high yield and improved low irradiation performance are achieved. Furthermore, by grouping two of the front side bus bars together so that they are adjacent each other, three sets of probes may be employed, rather than the typical five or six sets of probes, to contact bus bars during flash testing. The fewer number of probes used also reduces the shadow impact of the probes during the testing to thereby improve the accuracy and consistency of cell efficiency test.

The back side bus bars 148, 150, 152, 154, 156 are unevenly spaced apart across the solar cell 100. Specifically, the back side bus bars 148, 150, 152, 154, 156 are formed at locations on the back side 146 of the solar cell 100 such that upon cleaving the solar cell 100 into a plurality of strips made up of each of the discrete sections 106, 108, 110, 112, 114, the front side bus bar 116, 118, 120, 122, 124 of the strip is on an edge opposite from an edge on which a back side bus bar 148, 150, 152, 154, 156 is formed. For example, turning to FIG. 2, back side bus bar 148 is formed along the left edge 136 of the solar cell 100, while back side bus bar 156 is formed along the right edge 138 of the solar cell 100. Back side bus bars 150, 152, 154 are formed along a left edge of corresponding discrete sections 108, 110, 112.

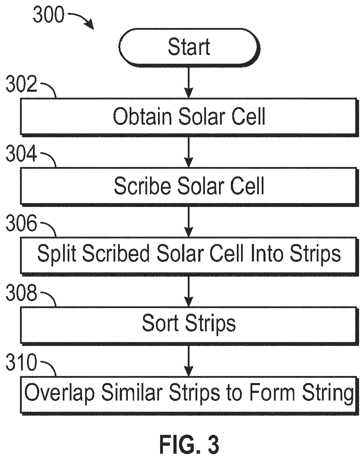

Having produced or been provided a solar cell 100, the process of building a SAM can begin. With reference to FIG. 3, a solar cell is obtained at step 302 of method 300. In an embodiment, the solar cell is tested, for example, using flash testing. In embodiments of solar cells including 5 strips, by grouping two bus-bars adjacent each other on the front side of the solar cell, three sets of probes can be used to contact bus-bars in flash testing, which may reduce the impact of shadow produced by the probes when a light is shined on the solar cell. Similarly, in embodiments in which 6 strips are included, by grouping two bus-bars adjacent each other, only five sets of probes may be used in flash testing instead of six sets of probes; alternatively, by grouping two bus-bars adjacent each other, only four sets of probes (rather than six sets of probes) may be used in flash testing.

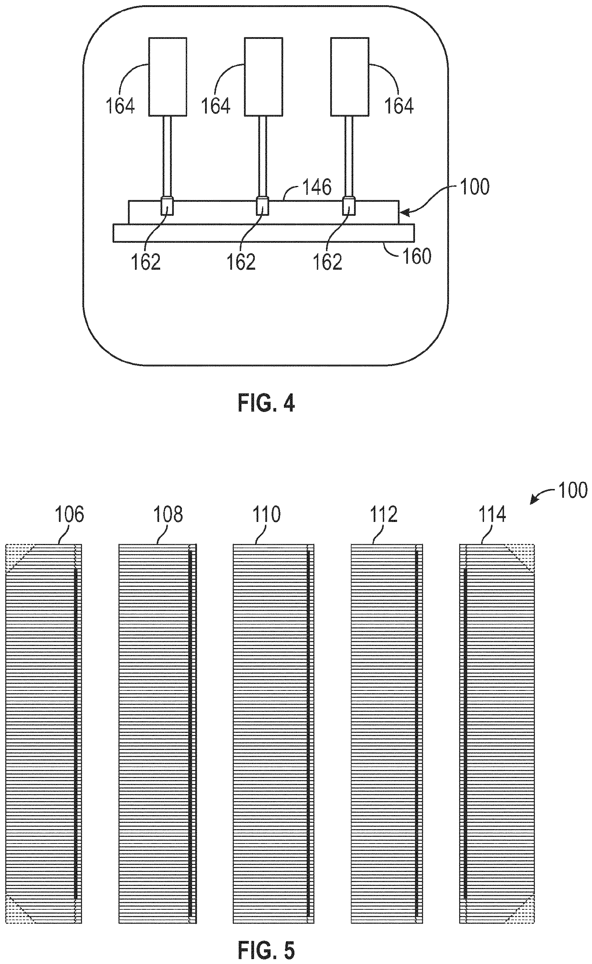

The solar cell is cut at step 304. Specifically, scribe lines are formed into the back surface of the solar cell so that when the solar cell is broken, the split occurs in the gap on the front surface of the solar cell between the discrete cells. Each scribe line has a depth of between about 10% and about 90% of wafer thickness. In an embodiment, the scribe lines extend across the solar cell from edge to edge. In another embodiment, one or both of the scribe lines extends from one edge to just short of an opposite edge of the solar cell. The scribe lines may be formed using a laser, a dicing saw and the like. In an embodiment, as illustrated in FIG. 4, a solar cell 100 is placed on a platform 160 back side 146 facing up so that scribe lines 162, may be formed in the solar cell 100. One or more lasers 164 are aligned at locations on the solar cell to form the scribe lines 162 along which the solar cell 100 will be singulated into strips.

Next, the scribed solar cell 100 is split at step 306. In an embodiment in which the solar cell may be singulated, the solar cell is placed on a vacuum chuck including a plurality of fixtures which are aligned adjacent each other to form a base. The vacuum chuck is selected so that the number of fixtures matches the number of discrete sections of the solar cell to be singulated into strips. Each fixture has apertures or slits, which provide openings communicating with a vacuum. The vacuum, when desired, may be applied to provide suction for mechanically temporarily coupling the solar cell to the top of the base. To singulate the solar cell, the solar cell is placed on the base such that the each discrete section is positioned on top of a corresponding one of the fixtures. The vacuum is powered on and suction is provided to maintain the solar cell in position on the base. Next, all of the fixtures move relative to each other. In an embodiment, multiple ones of the fixtures move a certain distance away from neighboring fixtures thereby causing the discrete sections of the solar cell to likewise move from each other and form resulting strips. In another embodiment, multiple ones of the fixtures are rotated or twisted relative to their longitudinal axes thereby causing the discrete sections of the solar cell to likewise move and form resulting strips. The rotation or twisting of the fixtures may be effected in a predetermined sequence, in an embodiment, so that no strip is twisted in two directions at once. In still another embodiment, mechanical pressure is applied to the back surface of the solar cell to substantially simultaneously break the solar cell into the strips. It will be appreciated that in other embodiments, other processes by which the solar cell is singulated alternatively may be implemented. Upon completion of singulation in step 306, the solar cell 100 is separated into its sections or strips 106-114 as shown in Fig. 5

After the solar cell is singulated, the strips are sorted in step 308. In particular, as shown in FIG. 5, the left-most and right-most strips 106 and 114, may have chamfered corners and, as a result, have dimensions that are different from strips 108, 110, and 112, which have non-chamfered corners and substantially identical dimensions. In an embodiment, sorting strips is achieved using an auto-optical sorting process. In another embodiment, the strips are sorted according to their position relative to the full solar cell. After sorting, strips 106, 114having chamfered corners are segregated from those strips 108, 110, 112 having non-chamfered corners. During sorting, strips can be arranged to align the bus bars into desired positions.

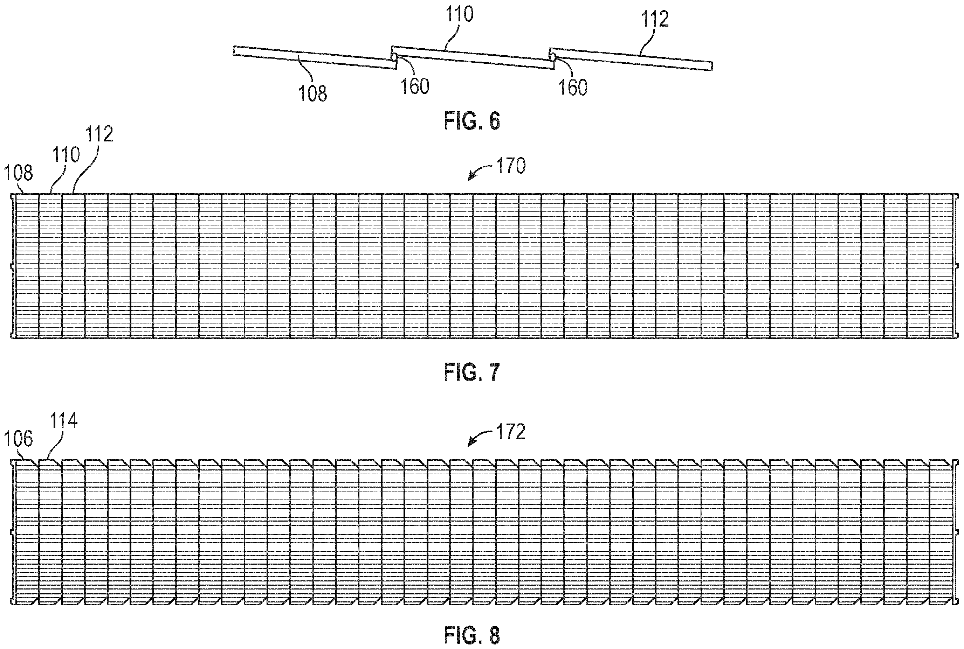

With continued reference to FIG. 3 and FIG. 6, similarly dimensioned strips are then placed in an overlapping arrangement to form a string in step 310. In an embodiment, an electrically-conductive adhesive 160 is applied to a front surface of the strip 108 along an edge including the front side bus bar 118 (FIG. 1). In another embodiment, the electrically-conductive adhesive is applied to a backside 146 surface of the strip 108, in at least one embodiment along the back side bus bar 150. The adhesive may be applied as a single continuous line, as a plurality of dots, dash lines, for example, by using a deposition-type machine configured to dispense adhesive material to a bus bar surface. In an embodiment, the adhesive is deposited such that it is shorter than the length of a corresponding bus bar and has a width and thickness to render sufficient adhesion and conductivity. After the adhesive is deposited onto the strip 108, the strip 108 and a second, similarly dimensioned strip 110 are aligned such that the back side bus bar of one strip 110 overlaps with the front side bus bar of the other strip 108, or alternatively, the front side bus bar of one strip overlaps with the back side bus bar of another. The steps of applying adhesive and aligning and overlapping the strips are repeated until a desired number of strips are adhered to form the string 170 (Fig. 7), or a string 172 (Fig. 8). The string 172 is formed of the strips 106 and 114 formed with the chamfered edges. Although step 310 is described as being performed on two strips, one or both of the strips may be pre-adhered to one or more other strips.

In an embodiment as illustrated in FIG. 7, non-chamfered strips 108, 110, and 112 are adhered to each other to form a string 170. The string includes 15 to 100 strips and each strip is overlapped such that the back side bus bar of each strip overlaps and is disposed over the front side bus bar of an adjacent strip, as depicted in Fig. 6. The string 170 of FIG. 7 also includes electrical connections for coupling to another similarly configured string. An end of the string 170 includes a metal foil soldered or electrically connected to the bus bar of each end strip which will be further connected to a module interconnect bus bar so that two or more strings together form the circuit of a solar module, as will be discussed in detail in subsequent paragraphs below. In another embodiment, the module interconnect busbar can be directly soldered or electrically connected to the bus bar of the end strip to form the circuit.

FIG. 8 illustrates another embodiment, a string 172 of chamfered corner strips 106, 114 where the back side bus bar of each strip 106, 114 overlaps and is disposed over the front side bus bar of an adjacent strip. Again, 15 to 100 strips make up the string 172.

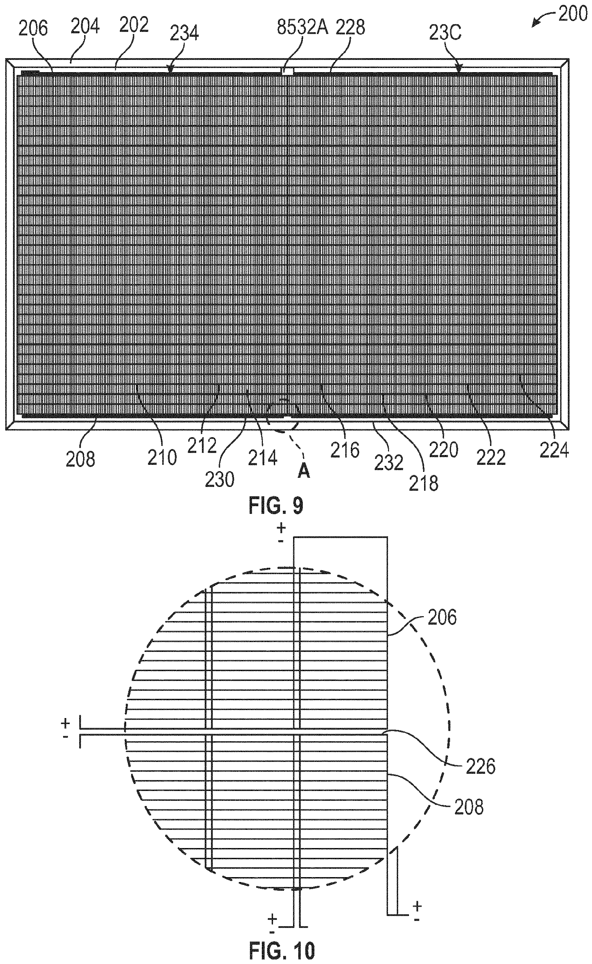

FIG 9. Is a front view, of a solar module 200 in accordance with an embodiment. The solar module 200 includes a back sheet 202 and a frame 204 surrounding all four edges of the back sheet 202. The back sheet 202 may be formed from polymer material, and the frame 204 may be formed from anodized aluminum or another lightweight rigid material.

Strings 206-224 of strips, ten of which are shown here, are disposed over the back sheet 202. Although not specifically depicted, it will be appreciated that a glass layer is placed over the strips and electrical connections associated therewith for protective purposes. Here, the strips are non-chamfered and have squared-off corners. The strings 206-224 are disposed side-by-side lengthwise, and as a result, each strip in each string extends along the back sheet 202 lengthwise so that the strips extend end-to-end.

In an embodiment, the edges of two adjacent strings 206-224 may be spaced apart providing a gap there between. As illustrated in FIG.11, which is a close up view of a portion of the solar module 200 encircled by "A", a gap 226 has a uniform width between the two adjacent strings 206, 208 in a range of between about 1 mm and about 5 mm. In another embodiment, the edges of two or more of the strings 206-224 are immediately adjacent each other.

The strings 206-224 are electrically coupled to the top bus bar 228 and the bottom bus bars 230, 232 each extending a length of the back sheet 202 on opposite edges. In an embodiment, a first string set 234 of five strings 206, 208, 210, 212, and 214 is connected via the top bus bar 228 and bottom bus bar 230, while a second string set 236 making up of the other five strings 216, 218, 220, 222, 224 is connected via top bus bar 228 and bottom bus bar 232. Each connection includes a conductive ribbon material adhered at one end to a corresponding strip and at another end to a corresponding bus bar. In this way, the strings 206-214 of the first string set 234 are connected in parallel, the strings 216-224 of the second string set 236 are connected in parallel, while the string sets 234 and 236 themselves are connected in series. An isolation strip (not shown) is disposed between the two string sets 234 and 236 to provide support between the string sets. The isolation strip is greater in length than the strings and is sufficiently wide to permit the adjacent strings 214 and 216 of the two string sets 234 and 236, respectively, to overlap a portion of the isolation strip.

Though the process of forming the solar module 200 has been generally described, there are several different methodologies that may be employed without departing from the scope of the present disclosure. In particular, the application of the ECA to the strips106-114 may be undertaken through the use of screen printing techniques. In screen printing, generally, a mask is employed. The mask includes openings or holes through which the printed material may pass and adhere to a substrate. The rest of the mask prevents the printed material from adhering to the substrate in undesired locations.

In the context of the present disclosure, the ECA may be screen printed onto the strips 106-114. As described above, following either step 306, the splitting of the cell into strips, or the sorting of the strips in in step 308, the strips may be arranged in a screen printing fixture. In one embodiment, the strips 108, 110, and 112 are arranged in a fixture, and in reality a large number of such strips (e.g., all rectangular strips) may be arranged in a fixture. For example 100, 200, 500 or more may be arranged in a fixture prior to screen printing of the ECA.

Next the mask is applied onto the fixture, or at least in a position where it is adjacent to the strips 108-112. ECA may then be printed onto the strips, that is a roller, press, squeegee, deposition system, spray nozzle, or other applicator system can be used to spread the ECA over the strips, such that ECA is able to adhere to the strips at the desired locations. As described above, this may be a continuous line across the entirety of the bus bar 118 on strip 108 or on bus bar 150, depending on whether screen printing the front sides or the back sides of the strips. Alternatively, the ECA can be dots, dashes, and other arrangements of ECA to create a connection point between the two strips 108-112, resulting in a string 170 as depicted in Fig. 7. A similar process may be employed to produce a string 172 as depicted in Fig. 8 using the chamfered strips 106, 114.

Further, though the present disclosure has been described in connection with a solar cell 100 having a particular configuration of bus bars the disclosure is not so limited. Other solar cell arrangements including more or fewer bus bars are contemplated herein, including 1, 2, 3, 4, 5, 6, and more bus bars. Further, the present disclosure contemplates the use of solar cells having no bus bars on one or both sides of the solar cell. In situations where one or the other sides of the solar cell have no bus bars, the ECA is applied to the strip at locations proximate the edge to enable shingling of the strips as depicted in Fig. 6.

Further, rather than bus bars, electrically conductive pads, which have a length dimension that is significantly smaller than the bus bars, may be employed to electrically connect the strips. These pads may be similar electroplated or deposited or screen printed Cu, Au, or Al (or other conductive material) that provide for low resistance conductivity between the strips. These pads may small rectangular, circular or other shaped connective material that electrically connects one or more fingerlines.

Still further, in one or more embodiments, the backside of the solar panel may have no bus bars and may have no fingerlines, but be formed of a solid sheet of conductive material.

While several embodiments of the disclosure have been shown in the drawings, it is not intended that the disclosure be limited thereto, as it is intended that the disclosure be as broad in scope as the art will allow and that the specification be read likewise. Any combination of the above embodiments is also envisioned and is within the scope of the appended claims. Therefore, the above description should not be construed as limiting, but merely as exemplifications of particular embodiments. Those skilled in the art will envision other modifications within the scope of the claims appended hereto.

## Claims

1. A method of forming a solar sub-assembly comprising:
etching a solar cell;
singulating the solar cell to form a plurality of strips, each strip including at least a bus bar;
screen printing electrically conductive adhesive (ECA) onto at least one edge of the singulated strips of the solar cell; and
shingling the singulated strips such that the ECA bonds one of the plurality of strips to another to form a string.

2. The method according to claim 1, further comprising applying a mask to the singulated strips of the solar cell to prevent adhesion of the ECA except where desired.

3. The method according to claim 1, wherein ECA is screen printed onto at least 100 singulated strips at a time.

4. The method according to claim 1, wherein 10 or more singulated strips are shingled to form a string.

5. The method according to claim 4, wherein 30 or more singulated strips are shingled to form a string.

6. The method according to claim 5, wherein 100 or more singulated strips are shingled to form a string.

7. The method according to claim 4, wherein two or more strings are electrically connected in parallel using a bus bar at both ends of the strings to form a set of strings.

8. The method according to claim 7, wherein two or more sets are connected electrically in series to form solar module.

9. The method according to claim 1, wherein the screen printing occurs applies ECA to substantially cover the at least one bus bar.

10. The method according to claim 9, wherein the screen printing applies a series of ECA dots, each having a length less than the full length of the bus bar.

11. The method according to claim 1, wherein the shingling requires overlaying an edge of a first singulated strip on which ECA has been applied on a first side, with a second edge of a second singulated strip on which no ECA has been applied.

12. The method according to claim 11, wherein the shingling is repeated until a desired length of a string has been achieved.
